# DEMANDE DE BREVET EUROPEEN

(11) **EP 0 604 333 A1**
(43) Date de publication de la demande: **29.06.1994**
(21) Numéro de dépôt: 93420503.0
(22) Date de dépôt: 20.12.1993
(51) Int. Cl.: H05K 7/14

(54) **Système d'interconnexion de cartes d'un système informatique rapide**

(30) Priorité: 24.12.1992 FR 9216015
(71) Demandeur: ADVANCED COMPUTER RESEARCH INSTITUTE S.A.R.L., F-92053 Paris La Défense (FR)
(72) Inventeur: Malardier, Pierre, F-38113 Veurey Voroise (FR)
(74) Mandataire: de Beaumont, Michel

(57) **Abrégé**

La présente invention concerne un système d'interconnexion formé d'un prisme dont les faces latérales externes sont munies de moyens de connexion (38) destinés à recevoir des cartes informatiques (40), dans le sens axial du prisme. Une pluralité de cartes d'interconnexion (30) sont juxtaposées dans des plans radiaux parallèles et relient entre elles des broches appropriées des moyens de connexion (38).

## Description

La présente invention concerne les systèmes dits de "fond de panier" permettant de connecter entre elles des cartes électroniques par insertion de ces cartes dans des connecteurs.

La présente invention vise plus particulièrement un système d'interconnexion des cartes d'un système informatique rapide.

Dans les sytèmes informatiques rapides, c'est-à-dire dont les composants peuvent individuellement fonctionner à une vitesse atteignant actuellement 250 MHz, les pistes conductrices reliant entre eux les sous-ensembles électroniques doivent être réalisées avec soin pour introduire une atténuation minimale. Pour cela, les pistes véhiculent des signaux dans un seul sens et sont réalisées sous forme de guides d'onde, ou lignes adaptées. Dans les meilleurs cas, ces lignes introduisent un retard de l'ordre de 60 picosecondes par centimètre.

On appelle distance critique la plus grande longueur de piste conductrice reliant deux sous-ensembles électroniques. Cette distance critique est la somme de deux distances critiques intra-carte (la plus grande longueur de piste entre un composant d'une carte et un connecteur de la carte) et d'une distance critique inter-cartes (la plus grande longueur d'une liaison entre deux cartes). La distance critique détermine la vitesse maximale de fonctionnement du système informatique, c'est-à-dire la fréquence maximale d'une horloge de synchronisation des sous-ensembles électroniques du système. En effet, le retard introduit par la distance critique ne doit pas dépasser une période d'horloge, sous peine d'avoir des lignes qui se comportent comme des lignes à retard stockant des informations pendant un ou plusieurs cycles d'horloge. Certains systèmes complexes sont adaptés à fonctionner avec de telles "lignes à retard" ; les lignes de données et d'adresses du système sont alors rigoureusement de même longueur et le système peut seulement fonctionner dans une plage de fréquences réduite, adaptée au retard des lignes.

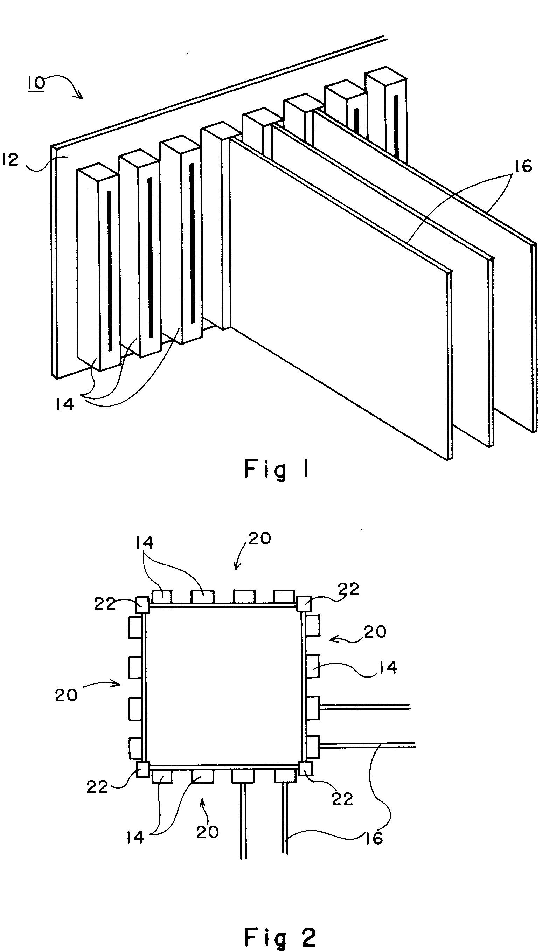

La figure 1 représente une vue en perspective d'un système d'interconnexion classique 10. Ce système comprend une carte de circuit imprimé plane 12 munie d'une pluralité de connecteurs verticaux 14 dont les broches appropriées sont reliées entre elles par des pistes formées sur la carte 12. On a représenté trois cartes 16 insérées dans trois des connecteurs.

La distance critique inter-cartes d'un tel système d'interconnexion est égale à la distance entre la première et la dernière carte insérée dans le système. En outre, l'espacement des cartes, déterminant directement la distanoe critique, dépend de la hauteur des composants montés sur les cartes. Comme ces composants travaillent à grande vitesse, ils dissipent une grande quantité de chaleur et doivent être munis de dissipateurs encombrants, refroidis par convection forcée. Ceci entraîne une augmentation considérable de l'espacement des cartes.

La figure 2 représente un autre type de système d'interconnexion classique permettant de réduire sensiblement la distance critique inter-cartes. Ce système comprend quatre sous-systèmes 20 du type de oelui de la figure 1 disposés pour former un parallélépipède. Chaque sous-système 20 est connecté à un sous-système adjacent par un connecteur 22.

Le système de connexion de la figure 2 présente une distance critique inter-cartes égale à deux distances critiques inter-cartes d'un sous-système 20. Pour un même nombre d'emplacements de carte, cette distance critique est environ deux fois inférieure à celle du système de la figure 1.

La demande de brevet européen 0 394 031 décrit un système d'interconnexion en étoile présentant une distance critique particulièrement faible. Il comprend plusieurs cartes électroniques connectées radialement à un empilement central de disques d'interconnexion. Chaque disque est un circuit imprimé multi-couches permettant de relier entre elles quelques broches de chaque carte électronique par l'intermédiaire de connecteurs verticaux. L'inconvénient de ce système est que le nombre de connexions entre un disque et une carte électronique est limité à quelques unités. Il ne convient pas à des systèmes qui requièrent des vitesses élevées de transmission de données, puisque de tels systèmes, comme cela a été mentionné, nécessitent des liaisons point à point et par conséquent un grand nombre de liaisons.

Un objet de la présente invention est de prévoir un système d'interconnexion en étoile présentant une densité de connexion particulièrement élevée.

L'invention atteint cet objet grâce à un système d'interconnexion en étoile formé d'un empilement central de cartes d'interconnexion, auquel des cartes électroniques sont connectées radialement. Chaque carte d'interconnexion est munie de connecteurs périphériques allongés disposés dans le plan de la carte d'interconnexion. Une pluralité de cartes intermédiaires sont munies chacune de connecteurs internes coopérant avec des connecteurs périphériques parallèles de l'empilement central. Les connecteurs internes de chaque carte intermédiaire sont reliés à au moins un connecteur externe disposé sur la carte intermédiaire du côté opposé aux connecteurs internes, relié aux connecteurs internes par des pistes conductrices de la carte intermédiaire, perpendiculaire aux connecteurs internes, et destiné à recevoir une carte électronique.

Selon un mode de réalisation de la présente invention, chaque carte intermédiaire comprend deux connecteurs externes parallèles.

Selon un mode de réalisation de la présente invention, les cartes électroniques connectées au système sont refroidies par un écoulement d'air axial.

Selon un mode de réalisation de la présente invention, les cartes électroniques et le système sont immergés dans un liquide de refroidissement.

Selon un mode de réalisation de la présente invention, certaines des cartes électroniques connectées au système comprennent, de leur côté distal, des cartes secondaires perpendiculaires.

Selon un mode de réalisation de la présente invention, chaque carte d'interconnexion comprend plusieurs couches de pistes conductrices séparées en couples de couches par des plans de masse. Chaque couche d'un couple comprend des pistes reliant les connecteurs périphériques en zig-zag, les couches d'un couple étant orientées de manière que les pistes d'une couche soient sensiblement perpendiculaires aux pistes de l'autre couche.

Selon un mode de réalisation de la présente invention, les pistes reliant sur une même couche deux connecteurs périphériques transmettent des signaux simultanés dans un même sens.

Selon un mode de réalisation de la présente invention, les pistes d'une même couche relient des contacts de rangs différents des connecteurs périphériques, les couches étant identiques mais décalées en rotation les unes par rapport aux autres de manière à relier tous les contacts des connecteurs périphériques.

Ces objets, caractéristiques, et avantages ainsi que d'autres de la présente invention seront exposés en détail dans la description suivante de modes de réalisation particuliers faite en relation avec les figures jointes parmi lesquelles :
les figures 1 et 2, précédemment décrites, représentent des systèmes d'interconnexion classiques ;
les figures 3A et 3B représentent respectivement sous forme éclatée une vue de dessus et une vue en perspective d'un mode de réalisation de système d'interconnexion selon l'invention ;
la figure 4 représente un ensemble de cartes électroniques reliées à un système d'interconnexion selon l'invention ; et
les figures 5A et 5B illustrent un mode de routage particulièrement avantageux d'une carte d'interconnexion.

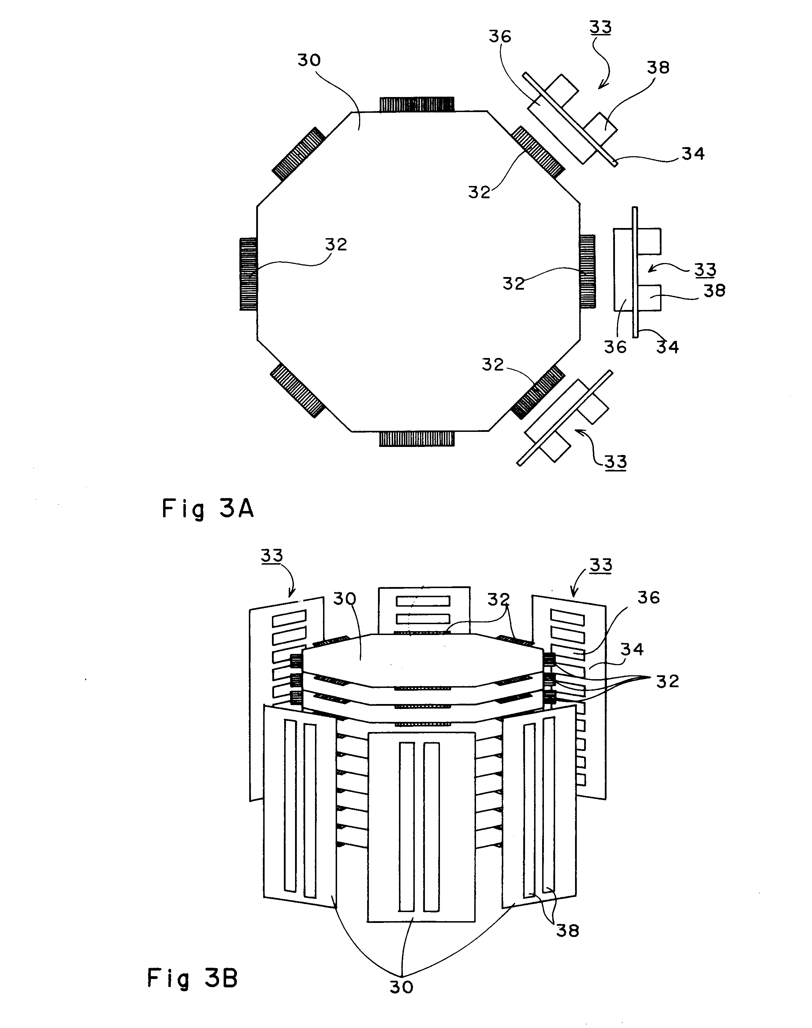

Les figures 3A et 3B représentent une vue de dessus et en perspective d'un système d'interconnexion en étoile. Il comprend un empilement vertical de cartes d'interconnexion 30.

Chaque carte d'interconnexion 30 est munie de connecteurs périphériques 32 disposés dans le plan de la carte d'interconnexion. Selon un aspect de l'invention, les connecteurs 32 sont allongés, ce qui donne une allure polygonale (octogonale dans l'exemple représenté) aux cartes d'interconnexion 30 et une allure prismatique à l'empilement.

Chaque connecteur périphérique 32 est formé par une extension radiale de la carte 30 associée et les contacts du connecteur 32 sont formés, par exemple, par des zones gravées sur la carte 30. Les contacts appropriés des connecteurs 32 d'une même carte 30 sont reliés entre eux par des pistes formées sur la carte.

L'empilement de cartes d'interconnexion 30 forme un prisme dont chaque face latérale, ou facette, comprend une pluralité de connecteurs 32 parallèles.

Selon un autre aspect de l'invention, sur chaque facette du prisme est monté un connecteur intermédiaire ou d'adaptation 33 destiné à raccorder les connecteurs parallèles 32 de la facette à une ou plusieurs cartes électroniques radiales, non représentées dans les figures 3A et 3B.

Avec cette configuration, chaque connecteur périphérique 32 d'une carte d'interconnexion 30 assure un nombre important de liaisons avec une carte électronique radiale correspondante.

Dans le mode réalisation représenté, chaque connecteur d'adaptation 33 est constitué d'une carte de circuit imprimé 34 qui porte, du côté intérieur, une pluralité de connecteurs horizontaux 36 destinés à recevoir les connecteurs 32 de la facette correspondante du prisme. Le circuit imprimé 34 porte, du côté extérieur un ou plusieurs connecteurs verticaux 38 occupant chacun sensiblement toute la hauteur du prisme et destinés à recevoir des cartes électroniques.

Les connecteurs 36 et 38 sont par exemple montés sur leurs cartes 34 correspondantes selon la technologie dite de montage en surface, ce qui évite que des broches traversantes des connecteurs d'une face viennent interférer avec les broches des connecteurs de l'autre face. Les broches de chaque connecteur 36 sont divisées en groupes. Les broches de chaque groupe sont reliées aux broches d'un connecteur 38 associé, le connecteur 38 le plus proche.

Selon une variante, les connecteurs 36 et 38 peuvent comprendre des zones de contact qui sont maintenues contre des zones de contact correspondantes du circuit imprimé 34.

Les connecteurs externes 38 sont, une fois que le prisme est assemblé, reliés à d'autres connecteurs externes 38 correspondants par l'intermédiaire de pistes qui traversent le prisme diagonalement. La distance de liaison la plus longue entre deux connecteurs 38, la distance critique inter-cartes, est sensiblement égale au diamètre du cercle inscrit dans un octogone 30.

La distance critique dépend du diamètre du cercle inscrit dans un octogone 30. Ce diamètre diminue avec la largeur des connecteurs intermédiaires 33 et diminue aussi si l'on diminue le nombre de facettes du prisme en supposant la largeur des facettes constante. Ainsi, on a tout intérêt à rapprocher le plus possible les connecteurs verticaux 38 et à avoir le moins de facettes de prisme possible. Bien entendu, si l'on ne prévoit qu'un connecteur externe 38 par facette, on réduit la largeur des faoettes. Toutefois, on verra ci-après que le fait de prévoir deux connecteurs externes par facette est une solution intéressante.

Par conséquent, si l'on connaît le nombre maximum de cartes à interconnecter, on choisira de réaliser un système d'interconnexion prismatique selon l'invention comprenant deux fois moins de facettes périphériques que le nombre maximal de cartes.

L'homme du métier saura trouver une solution mécanique pour fixer les cartes 30 les unes par rapport aux autres et/ou par rapport aux connecteurs 33. Par exemple, on pourra prévoir de fixer à chaque angle des cartes 30 une pièce en équerre sur laquelle on fixe les cartes 34 par des vis.

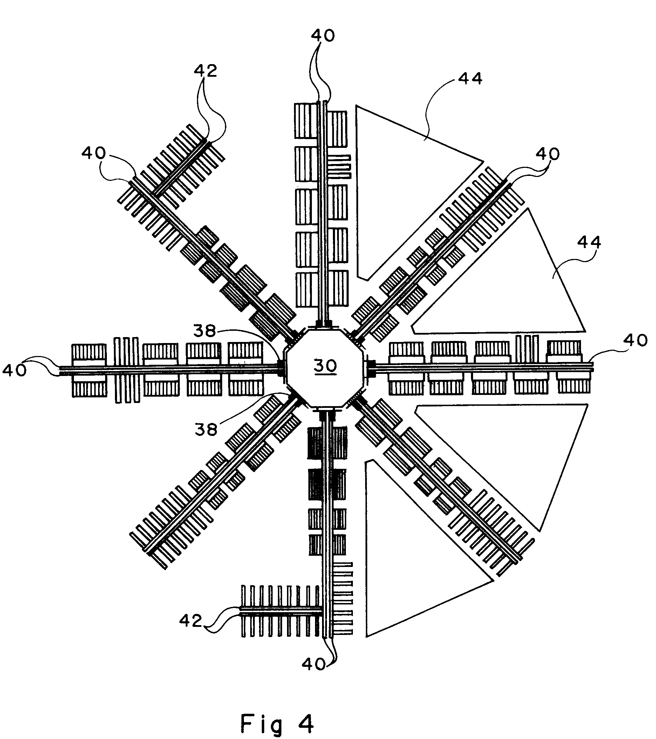

La figure 4 représente un ensemble de cartes électroniques connectées à un système d'interconnexion prismatique selon l'invention. Une carte électronique 40 est insérée dans chacun des connecteurs externes 38. Un seul côté de chaque carte 40 est muni de composants électroniques et les deux cartes 40 insérées dans les deux connecteurs d'une même facette du prisme sont telles que les faces dépourvues de composants soient tournées l'une vers l'autre. Avec cette disposition, les connecteurs externes 38 de chaque facette du prisme peuvent être disposés très près l'un de l'autre. En fait, ce qui limite le plus la largeur minimale des facettes du prisme est l'encombrement des composants disposés du côté le plus proche du prisme, du côté proximal des cartes 40. Cette largeur est aussi limitée par la longueur des connecteurs 32, qui est déterminée par le nombre de signaux que chaque connecteur 32 doit véhiculer. Les connecteurs 32 sont de préférence des connecteurs "haute densité" de manière que leur longueur soit réduite.

Comme on le voit sur la figure 4, on dispose d'un important volume au niveau des côtés distaux des cartes 40. Ce volume peut être avantageusement occupé en partie par des cartes secondaires 42 connectées perpendiculairement aux cartes 40. Cette disposition a pour avantage de réduire l'encombrement d 'ensemble et de diminuer la distance critique entre les composants des cartes secondaires 42 et le système d'interconnexion prismatique.

Afin de réduire la quantité de chaleur émise par unité de surface, on a intérêt à occuper au maximum le volume disponible qui croit rapidement avec la longueur des cartes 40 et à limiter les zones vides en les remplissant par des cartes secondaires 42.

Une première solution de refroidissement consiste à munir les composants de dissipateurs thermiques et, grâce à des ventilateurs, à faire circuler de l'air verticalement dans le volume inoccupé. On peut éventuellement prévoir entre les cartes 40 des colonnes 44 de guidage d'air munies de sorties d'air au niveau des dissipateurs des composants.

Une autre solution de refroidissement consiste à immerger l'ensemble des cartes 40, 42 connectées au prisme dans un liquide de refroidissement que l'on fait, par exemple, circuler en circuit fermé dans un échangeur. Dans ce cas, il est inutile de munir les composants de dissipateurs, ce qui diminue considérablement leur encombrement. Par conséquent, la largeur des faces du prisme peut être réduite de façon notable et la distance critique de même.

A titre d'exemple, pour un même système informatique à système d'interconnexion octogonal dissipant environ 16 kW, on obtient une distance critique de 31 cm et un encombrement de 284 litres dans une configuration refroidie par air, et une distance critique de 20 cm et un encombrement de 89 litres dans une configuration refroidie par liquide.

La présente invention vise également un mode de réalisation particulièrement avantageux des cartes d'interconnexion 30.

Dans des circuits imprimés à réseaux de pistes de haute densité, et notamment qui véhiculent des signaux de grande vitesse, il survient des phénomènes de diaphonie. Si l'on considère deux pistes proches, un front se propageant sur l'une des pistes entraîne une perturbation sur l'autre piste par des couplages capacitifs et inductifs. Cette perturbation se traduit généralement par une impulsion parasite qui arrive à un instant inattendu sur un circuit récepteur. Le circuit récepteur risque d'interpréter erronément oette impulsion comme une transition.

La diaphonie entre deux pistes est d'autant plus importante que les pistes sont parallèles sur une longue distance et que les fronts de transition des signaux sur les pistes sont raides.

Pour atténuer la diaphonie, on sépare classiquement plusieurs couches de pistes par des plans de masse, et on essaie d'effectuer des réseaux de pistes moins denses sur les couches. Toutefois, cette solution requiert des circuits imprimés à grand nombre de couches et un grand soin du dessin des pistes (routage des pistes) pour que deux pistes proches soient parallèles sur la longueur la plus faible possible.

La présente invention propose un mode de routage particulièrement avantageux des cartes d'interconnexion 30, permettant de réduire notablement les phénomènes de diaphonie. En outre, ce mode de routage est particulièrement simple et permet de réaliser les cartes d'interconnexion 30 à faible coût.

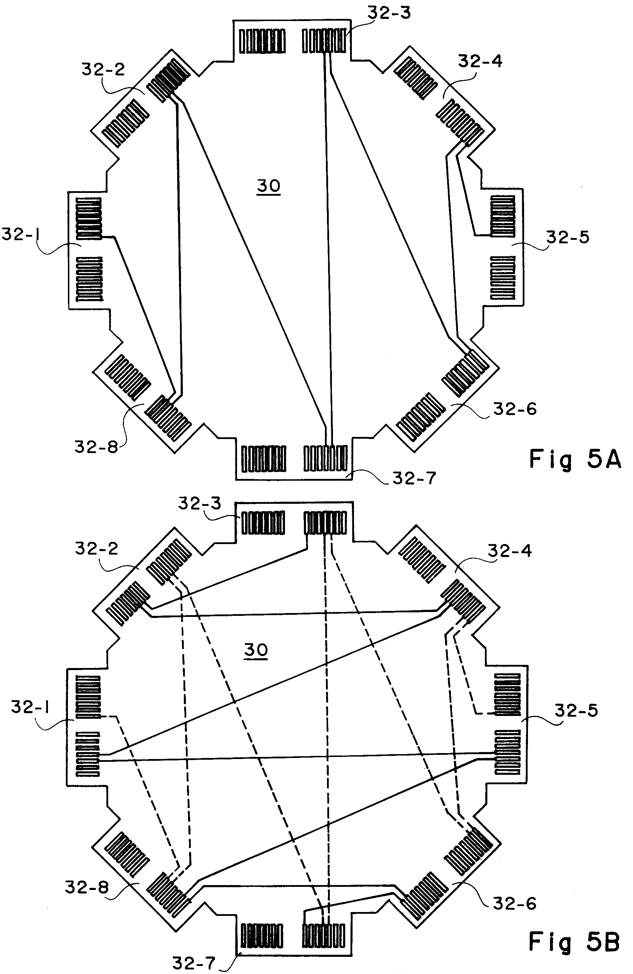

Les figures 5A et 5B représentent une carte d'interconnexion 30 à deux étapes d'un routage selon l'invention.

Chaque connecteur périphérique 32 comprend un ensemble de contacts qui peut, comme cela est représenté, être subdivisé en deux sous-ensembles, chaque sous-ensemble correspondant à un connecteur vertical 38 (figures 3A et 3B). Dans le présent exemple, une carte d'interconnexion 30 est octogonale et munie de huit connecteurs périphériques 32 désignés respectivement par 32-1 à 32-8, dans le sens horaire. A titre d'exemple, on suppose que chaque connecteur périphérique 32 comprend 14 contacts de rangs 1 à 14 dans le sens horaire.

La figure 5A illustre un exemple de routage selon l'invention d'une première couche d'une carte d'interconnexion 30. Les connecteurs périphériques 32 sont reliés entre eux en zig-zag. Par exemple, à la figure 5A, les connecteurs 32 sont reliés entre eux selon la succession suivante : 32-1, 32-8, 32-2, 32-7, 32-3, 32-6, 32-4, et 32-5. Avec cette disposition, la diaphonie entre deux pistes d'une même couche est réduite grâce au fait que les pistes s'écartent rapidement les unes des autres en partant d'un connecteur 32.

En outre, chaque rang des contacts est utilisé une seule fois sur une couche. Dans l'exemple de la figure 5A, en partant du connecteur 32-1, on utilise successivement les rangs 8, 6, 5, 9, 10, 4, 3, 11, 12, 2, 1, 13, 14, et 7. En opérant de cette manière, il suffit, pour établir toutes les connexions entre les connecteurs 32, de prévoir, dans l'exemple de la figure 5A, huit couches de circuit imprimé où chaque couche comporte le motif de la figure 5A tourné de 45° par rapport à une couche précédente. Bien entendu, il s'agit ici d'un système d'interconnexion point à point où une broche est reliée à une seule autre broche.

La figure 5B illustre une deuxième étape de routage selon l'invention. On a représenté en pointillés les pistes correspondant à la couche de la figure 5A et en trait plein les pistes d'une deuxième couche. Ces dernières pistes correspondent exactement à celles de la figure 5A tournées de 90° dans le sens horaire.

Comme cela est visible sur la figure 5B, les pistes de la première couche (en pointillés) croisent celles de la deuxième couche (en trait plein) pratiquement selon des angles droits. Ceci entraîne une diaphonie minimale entre les pistes de ces deux couches et il est inutile de prévoir un plan de masse pour séparer ces deux couches. Pour établir toutes les connexions entre les connecteurs 32, on recopie trois fois le couple de couches de la figure 5B en faisant tourner les copies par rapport au premier couple respectivement de 45°, 135° et 225° dans le sens horaire. Les couples de couches ainsi constitués sont séparés par des plans de masse.

On a représenté à titre d'exemple une seule piste reliant un connecteur 32 à un autre. Bien entendu, le nombre de contacts de chaque connecteur 32 peut être multiplié et on peut prévoir sur une même couche de multiples pistes parallèles reliant un connecteur 32 à l'autre. On a alors un risque de diaphonie entre ces pistes parallèles.

Toutefois, on choisit ces pistes parallèles de manière qu'elles correspondent à des signaux émis simultanément dans le même sens, ce qui est très courant dans un système informatique où l'on émet des données et des adresses sur de nombreuses lignes. Dans ce cas, des perturbations de diaphonie se propagent sur les pistes parallèles en même temps que les fronts des signaux. De cette manière, on sait à quels instants arrivent des perturbations sur un circuit récepteur : elles sont synchrones à une horloge déterminant les fronts des signaux. Le circuit récepteur sera conçu pour prendre en compte les signaux avec un léger retard par rapport aux fronts, c'est-à-dire à des instants où les perturbations sont passées.

## Revendications

1. Système d'interconnexion en étoile formé d'un empilement central de cartes d'interconnexion (30), auquel des cartes électroniques (40) sont connectées radialement, caractérisé en ce que chaque carte d'interconnexion est munie de connecteurs périphériques allongés (32) disposés dans le plan de la carte d'interconnexion, et en ce qu'il comprend une pluralité de cartes intermédiaires (34) dont chacune est munie de connecteurs internes (36) coopérant avec des connecteurs périphériques (32) parallèles de l'empilement central, les connecteurs internes de chaque carte intermédiaire étant reliés à au moins un connecteur externe (38) disposé sur la carte intermédiaire du côté opposé aux connecteurs internes, relié aux connecteurs internes par des pistes conductrices de la carte intermédiaire, perpendiculaire aux connecteurs internes, et destiné à recevoir une carte électronique (40).

2. Système d'interconnexion selon la revendication 1, caractérisé en ce que chaque carte intermédiaire (34) comprend deux connecteurs externes (38) parallèles.

3. Système d'interconnexion selon la revendication 1, caractérisé en ce que les cartes électroniques (40) connectées au système sont refroidies par un écoulement d'air axial.

4. Système d'interconnexion selon la revendication 1, caractérisé en ce que les cartes électroniques (40) et le système sont immergés dans un liquide de refroidissement.

5. Système d'interconnexion selon la revendication 1, caractérisé en ce que certaines des cartes électroniques (40) connectées au système comprennent, de leur côté distal, des cartes secondaires perpendiculaires.

6. Système d'interconnexion selon la revendication 1, caractérisé en ce que chaque carte d'interconnexion (30) comprend plusieurs couches de pistes conductrices séparées en couples de couches par des plans de masse, chaque couche d'un couple comprenant des pistes reliant les connecteurs périphériques en zig-zag, les couches d'un couple étant orientées de manière que les pistes d'une couche soient sensiblement perpendiculaires aux pistes de l'autre couche.

7. Système d'interconnexion selon la revendication 6, caractérisé en ce que les pistes reliant sur une même couche deux connecteurs périphériques (32) transmettent des signaux simultanés dans un même sens.

8. Système d'interconnexion selon la revendication 6, caractérisé en ce que les pistes d'une même couche relient des contacts de rangs différents des connecteurs périphériques (32), les couches étant identiques mais décalées en rotation les unes par rapport aux autres de manière à relier tous les contacts des connecteurs périphériques.
